# EUROPEAN PATENT SPECIFICATION

(11) **EP 1 070 276 B1**
(45) Date of publication and mention of the grant of the patent: **01.06.2005**
(21) Application number: 99916582.2
(22) Date of filing: 09.04.1999
(51) Int. Cl.: G02F 1/167

(54) **FULL COLOR REFLECTIVE DISPLAY WITH MULTICHROMATIC SUB-PIXELS**
MEHRFAHRBIGE REFLEKTIERENDE ANZEIGEVORRICHTUNG MIT POLYCHROMATISCHEN SUBPIXELN
AFFICHAGE REFLECHISSANT EN COULEURS AVEC SOUS-PIXELS MULTICHROMATIQUES

(30) Priority: 10.04.1998 US 81362 P
(43) Date of publication of application: 24.01.2001
(60) Divisional application: 05007269.3
(73) Proprietor: E-Ink Corporation, Cambridge, MA 02138-1002 (US)
(72) Inventor: DRZAIC, Paul, Lexington, MA 02421 (US); WILCOX, Russell, J., Natick, MA 01760 (US)
(74) Representative: Cole, David John
(86) International application number: PCT/US1999/007850
(87) International publication number: WO 1999/053373

(56) References cited:
- WO-A-99/10768
- US-A- 3 870 517
- US-A- 5 380 362
- COMISKEY B ET AL: "7.4L: LATE-NEWS PAPER: ELECTROPHORETIC INK: A PRINTABLE DISPLAY MATERIAL" 1997 SID INTERNATIONAL SYMPOSIUM DIGEST OF TECHNICAL PAPERS, BOSTON, MAY 13 - 15, 1997, no. VOL. 28, 13 May 1997 (1997-05-13), page 75/76 XP000722661 SOCIETY FOR INFORMATION DISPLAY ISSN: 0097-966X
- PATENT ABSTRACTS OF JAPAN vol. 014, no. 027 (P-992), 19 January 1990 (1990-01-19) & JP 01 267525 A (TOYOTA MOTOR CORP), 25 October 1989 (1989-10-25)

## Description

The present invention relates to electronic displays and, in particular, to color electrophoretic displays and methods of creating color microencapsulated electrophoretic displays.

There are a number of enhanced reflective display media which offer numerous benefits such as enhanced optical appearance, the ability to be constructed in large form factors, capable of being formed using flexible substrates, characterized by easy manufacturability and manufactured at low cost. Such reflective display media include microencapsulated electrophoretic displays, rotating ball displays, suspended particle displays, and composites of liquid crystals with polymers (known by many names including but not limited to polymer dispersed liquid crystals, polymer stabilized liquid crystals, and liquid crystal gels). Electrophoretic display media, generally characterized by the movement of particles through an applied electric field, are highly reflective, can be made bistable, and consume very little power. Further, encapsulated electrophoretic displays also may be printed. These properties allow encapsulated electrophoretic display media to be used in many applications for which traditional electronic displays are not suitable, such as flexible, printed displays.

While bichromatic electrophoretic displays have been demonstrated in a limited range of colors (e.g. black/white or yellow/red), to date there has not been successful commercialization of a full-color electrophoretic display. Indeed, no reflective display technology to date has shown itself capable of satisfactory color. Full-color reflective displays typically are deficient when compared to emissive displays in at least two important areas: brightness and color saturation.

One traditional technique for achieving a bright, full-color display which is known in the art of emissive displays is to create sub-pixels that are red, green and blue. In this system, each pixel has two states: on, or the emission of color; and off. Since light blends from these sub-pixels, the overall pixel can take on a variety of colors and color combinations. In an emissive display, the visual result is the summation of the wavelengths emitted by the sub-pixels at selected intensities, white is seen when red, green and blue are all active in balanced proportion or full intensity. The brightness of the white image is controlled by the intensities of emission of light by the sub-pixels. Black is seen when none are active or, equivalently, when all are emitting at zero intensity. As an additional example, a red visual display appears when the red sub-pixel is active while the green and blue are inactive, and thus only red light is emitted.

It is known that this method can be applied to bichromatic reflective displays, typically using the cyan-magenta-yellow subtractive color system. In this system, the reflective sub-pixels absorb characteristic portions of the optical spectrum, rather than generating characteristic portions of the spectrum as do the pixels in an emissive display. White reflects everything, or equivalently absorbs nothing. A colored reflective material reflects light corresponding in wavelength to the color seen, and absorbs the remainder of the wavelengths in the visible spectrum. To achieve a black display, all three sub-pixels are turned on, and they absorb complementary portions of the spectrum.

However, the colors displayed by a full-color display as described above are sub-optimal. For example, to display red, one pixel displays magenta, one displays yellow, and one displays white. The white sub-pixel reduces the saturation of red in the image and reduces display contrast. The overall effect is a washed out red. This further illustrates why no method to date has been capable of generating a high-contrast, high-brightness full color reflective display with good color saturation.

This invention teaches practical ways to achieve brighter, more saturated, reflective color displays than previously known, particularly color encapsulated, electrophoretic displays.

This invention seeks to provide a brighter, more saturated, reflective . color display. In some embodiments, the displays are highly flexible, can be manufactured easily, consume little power, and can, therefore, be incorporated into a variety of applications. The invention features a printable display comprising an encapsulated electrophoretic display medium. In an embodiment the display media can be printed and, therefore the display itself can be made inexpensively.

An encapsulated electrophoretic display can be constructed so that the optical state of the display is stable for some length of time. When the display has two states which are stable in this manner, the display is said to be bistable. If more than two states of the display are stable, then the. display can be said to be multistable. For the purpose of this invention, the terms bistable and multistable, or generally, stable, will be used to indicate a display in which any optical state remains fixed once the addressing voltage is removed. The definition of a stable state depends on the application for the display. A slowly-decaying optical state can be effectively stable if the optical state is substantially unchanged over the required viewing time. For example, in a display which is updated every few minutes, a display image which is stable for hours or days is effectively bistable or multistable, as the case may be, for that application. In this invention, the terms bistable and multistable also indicate a display with an optical state sufficiently long-lived.as to be effectively stable for the application in mind. Alternatively, it is possible to construct encapsulated electrophoretic displays in which the image decays quickly once the addressing voltage to the display is removed (i.e., the display is not bistable or multistable). As will be described, in some applications it is advantageous to use an an encapsulated electrophoretic display which is not bistable or multistable. Whether or not an encapsulated electrophoretic display is stable, and its degree of stability, can be controlled through appropriate chemical modification of the electrophoretic particles, the suspending fluid, the capsule, and binder materials.

An encapsulated electrophoretic display may take many forms. The display may comprise capsules dispersed in a binder. The capsules may be of any size or shape. The capsules may, for example, be spherical and may have diameters in the millimeter range or the micron range, but is preferably from ten to a few hundred microns. The capsules may be formed by an encapsulation technique, as described below. Particles may be encapsulated in the capsules. The particles may be two or more different types of particles. The particles may be colored, luminescent, light-absorbing or transparent, for example. The particles may include neat pigments, dyed (laked) pigments or pigment/polymer composites, for example. The display may further comprise a suspending fluid in which the particles are dispersed.

The successful construction of an encapsulated electrophoretic display requires the proper interaction of several different types of materials and processes, such as a polymeric binder and, optionally, a capsule membrane. These materials must be chemically compatible with the electrophoretic particles and fluid, as well as with each other. The capsule materials may engage in useful surface interactions with the electrophoretic particles, or may act as a chemical or physical boundary between the fluid and the binder. Various materials and combinations of materials useful in constructing encapsulated electrophoretic displays are described in WO-A-99/10767.

In some cases, the encapsulation step of the process is not necessary, and the electrophoretic fluid may be directly dispersed or emulsified into the binder (or a precursor to the binder materials) and an effective ''polymer-dispersed electrophoretic display" constructed. In such displays, voids created in the binder may be referred to as capsules or microcapsules even though no capsule membrane is present. The binder dispersed electrophoretic display may be of the emulsion or phase separation type.

An encapsulated electrophoretic display is described in Comiskey, B., et al., "7.4L: Late-News Paper: Electrophoretic Ink: A Printable Display Material", 1997 SID International Symposium Digest of Technical Papers, Boston, May 13-15, 1997, Vol. 28, 13 May 1997, pages 75-76, Society for Information Display ISSN: 0097-966X.

Throughout the specification, reference will be made to printing or printed. As used throughout the specification, printing is intended to include all forms of printing and coating, including: premetered coatings such as patch die coating, slot or extrusion coating, slide or cascade coating, and. curtain. coating; roll coating such as knife over roll coating, forward and reverse roll coating; gravure coating; dip coating; spray coating; meniscus coating; spin coating; brush coating; air knife coating; silk screen printing processes; electrostatic printing processes; thermal printing processes; and other similar techniques. A "printed element" refers to an element formed using any one of the above techniques.

As noted above, electrophoretic display elements can be encapsulated. Throughout the Specification, reference will be made to "capsules," "pixels," and "sub-pixels." A pixel display element can be formed by one or more capsules or sub-pixels. A sub-pixel may itself comprise one or more capsules or other structures.

The present invention provides an electrophoretic display element which includes a capsule generally similar to those described in the aforementioned Comiskey et al. paper but which employs color filters to provide different visual states. Thus, the present invention provides an electrophoretic display element comprising a capsule including at least one. species of particles with a color, the element ,presenting a visual display in response to the application of an electrical signal to the capsule. This electrophoretic display element is characterized by a filter having a color visually different from that of the species of particles , the filter being disposed adjacent the capsule such that, in at least one optical state of the element, light incident on the capsule will pass through the filter so that the visual appearance of the capsule is modified by the presence of the filter.

The electrophoretic display element can have capsules which include a suspending fluid. The suspending fluid can be substantially clear, or it can be dyed or otherwise colored.

The display apparatus can include a plurality of electrodes adjacent the display element. The plurality of electrodes can include at least one which has a size different from others of the plurality of electrodes.

The advantages of the invention described above, together with further advantages, may be better understood by referring to the following description taken in conjunction with the accompanying drawings. In the drawings, like reference characters generally refer to the same parts throughout the different views. Also, the drawings are not necessarily to scale, emphasis instead generally being placed upon illustrating the principles of the invention.

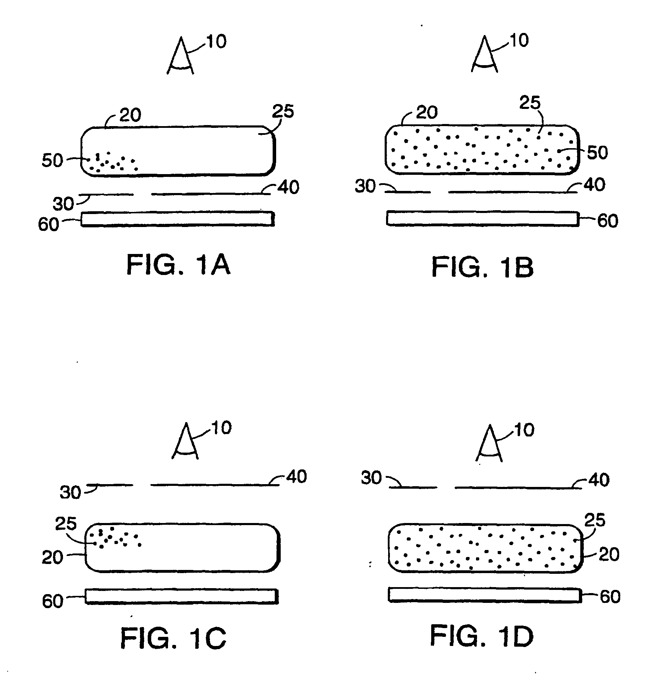

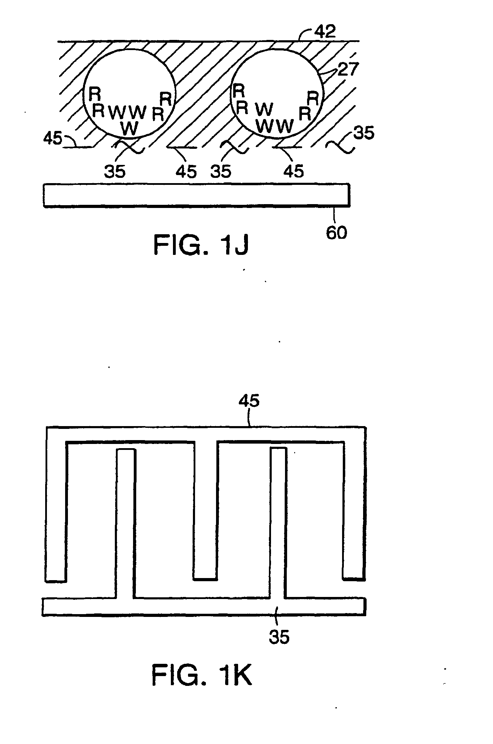

FIG. 1A is a diagrammatic side view of an electrophoretic display element of the invention and associated electrodes forming a rear-addressing electrode structure for a particle-based display in which a smaller electrode has been placed at a voltage relative to the large electrode causing the particles to migrate to the smaller electrode.
FIG. 1B is a diagrammatic side view of the electrophoretic display of FIG. 1A after an alternating-current electric field has been applied to the capsule causing the particles to disperse into the capsule, obscuring a rear substrate.
FIG. 1C is a diagrammatic side view of a second electrophoretic display element of the invention and associated electrodes forming an addressing structure having transparent electrodes, in which a direct-current electric field has been applied to the capsule causing the particles to migrate to the smaller electrode, revealing a rear substrate.
FIG. 1D is a diagrammatic side view of the electrophoretic display of FIG. 1C after an alternating-current electric field has been applied to the capsule causing the particles to disperse into the capsule.

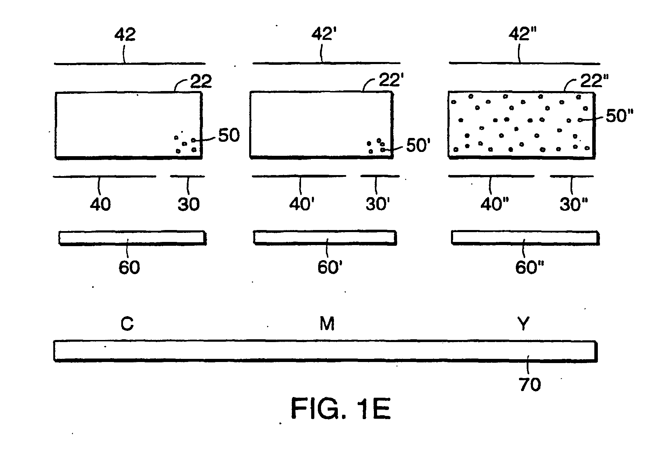

FIG. 1E is a diagrammatic side view of a third electrophoretic display element of the invention and associated electrodes forming an addressing structure for a display element having three sub-pixels.

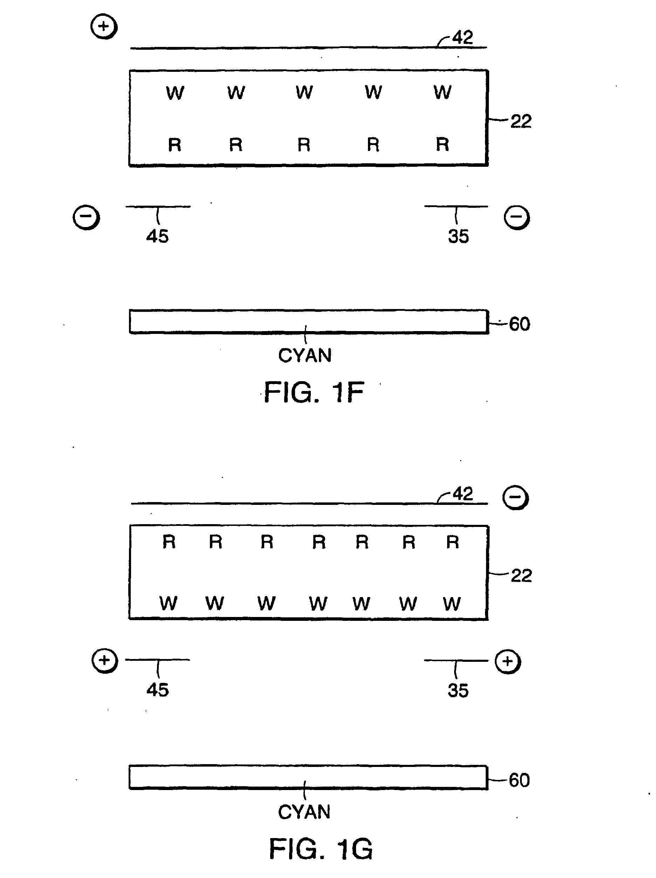

FIG. 1F is a diagrammatic side view of a fourth electrophoretic display element of the invention and associated electrodes forming a dual particle curtain mode addressing structure, the display element being addressed to appear white.
FIG. 1G is a diagrammatic side view of the display element of FIG. 1F addressed to appear red.

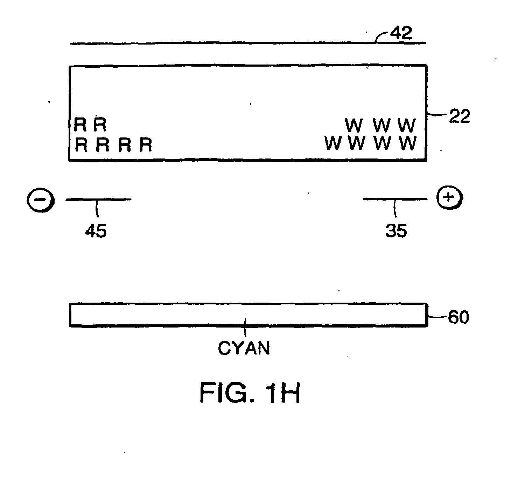

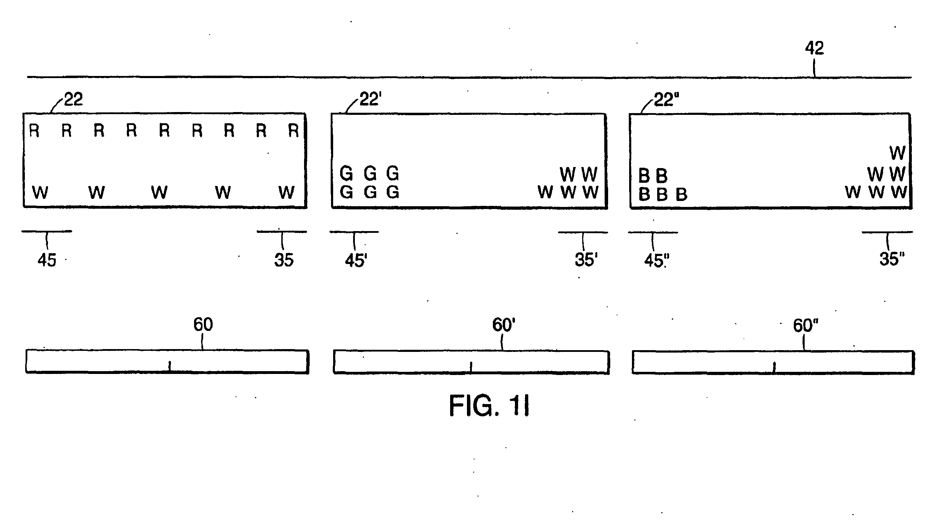

FIG. 1H is a diagrammatic side view of the display element of FIG. 1F addressed to absorb red light.
FIG. 1I is a diagrammatic side view of an embodiment of a dual particle curtain mode display element of the invention having three sub-pixels, the display element being addressed to appear red.
FIG. 1J is a diagrammatic side view of another embodiment of a dual particle curtain mode display element of the invention.
FIG. 1K is a diagrammatic plan view of an embodiment of an interdigitated electrode structure.

An electronic ink is an optoelectronically active material that comprises at least two phases: an electrophoretic contrast media phase and a coating/binding phase. The electrophoretic phase comprises, in some embodiments, a single species of electrophoretic particles dispersed in a clear or dyed medium, or more than one species of electrophoretic particles having distinct physical and electrical characteristics dispersed in a clear or dyed medium. In some embodiments the electrophoretic phase is encapsulated, that is, there is a capsule wall phase between the two phases. The coating/binding phase includes, in one embodiment, a polymer matrix that surrounds the electrophoretic phase. In this embodiment, the polymer in the polymeric binder is capable of being dried, crosslinked, or otherwise cured as in traditional inks, and therefore a printing process can be used to deposit the electronic ink onto a substrate.

An electronic ink is capable of being printed by several different processes, depending on the mechanical properties of the specific ink employed. For. example, the fragility or viscosity of a particular ink may result in a different process selection. A very viscous ink would not be well-suited to deposition by an inkjet printing process, while a fragile ink might not be used in a knife over roll coating process.

The optical quality of an electronic ink is quite distinct from other electronic display materials. The most notable difference is that the electronic ink provides a high degree of both reflectance and contrast because it is pigment based (as are ordinary printing inks). The light scattered from the electronic ink comes from a very thin. layer of pigment close . to the , top of the viewing surface. In this respect it resembles an ordinary, printed image. Also, electronic ink is easily viewed from a wide range of viewing angles in the same manner as a printed page, and such ink approximates a Lambertian contrast curve more closely than any other electronic display material. Since electronic ink can be printed, it can be included on the same surface with any other printed material, including traditional inks. Electronic ink can be made optically stable in all display configurations, that is, the ink can be set to a persistent optical state. Fabrication of a display by printing an electronic ink is particularly useful in low power applications because of this stability.

Electronic ink displays are novel in that they can be addressed by DC voltages and draw very little current. As such, the conductive leads and electrodes used to deliver the voltage to electronic ink displays can be of relatively high resistivity. The ability to use resistive conductors substantially widens the number and type of materials that can be used as conductors in electronic ink displays. In particular, the use of costly vacuum-sputtered indium tin oxide (ITO) conductors, a standard material in liquid crystal devices, is not required. Aside from cost savings, the replacement of ITO with other materials can provide benefits in appearance, processing capabilities (printed conductors), flexibility, and durability. Additionally, the printed electrodes are in contact only with a solid binder, not with a fluid layer (like liquid crystals). This means that some conductive materials, which would otherwise dissolve or be degraded by contact with liquid crystals, can be used in an electronic ink application. These include opaque metallic inks for the rear electrode (e.g., silver and graphite inks), as well as conductive transparent inks for either substrate. These conductive coatings include semiconducting colloids, examples of which are indium tin oxide and antimony-doped tin oxide. Organic conductors (polymeric conductors and molecular organic conductors) also may be used. Polymers include, but are not limited to, polyaniline and derivatives, polythiophene and derivatives, poly(3,4-ethylenedioxythiophene) (PEDOT) and derivatives, polypyrrole and derivatives, and polyphenylenevinylene (PPV) and derivatives. Organic molecular conductors include, but are not limited to, derivatives of naphthalene, phthalocyanine, and pentacene. Polymer layers can be made thinner and more transparent than with traditional displays because conductivity requirements are not as stringent.

As an example, there are a class of materials called electroconductive powders which are also useful as coatable transparent conductors in electronic ink displays. One example is Zelec ECP electroconductive powders from DuPont Chemical Co. of Wilmington, Delaware.

It is possible to produce any selected color from the superposition of suitable proportions of three properly chosen colors. In one embodiment, the colors red, green, and blue can be combined in various proportions to produce an image which is perceived as a selected color. Emissive or transmissive displays operate according to additive rules, where the perceived color is created by summing the . emission wavelengths of a plurality of emitting or transmitting objects. For an emissive or transmissive display which includes three sub-pixels, one of which can produce red light, one green light, and one blue light, respectively, one can generate all colors, as well as white and black. At one extreme, the combination of all three at full intensity is perceived as white, and at the other, the combination of all three at zero intensity is perceived as black. Specific combinations of controlled proportions of these three colors can be used to represent other colors.

In a reflective display, the light which a viewer perceives is the portion of the spectrum which is not absorbed when the light to be reflected falls on the reflector surface. One may thus consider a reflecting system as a subtractive system, that is, that each reflective surface "subtracts" from the light that portion which the reflector absorbs. The color of a reflector represents the wavelengths of light the reflector absorbs. A yellow reflector absorbs substantially blue light. A magenta reflector absorbs substantially green light. A cyan reflector absorbs substantially red light. Thus, in an alternative embodiment employing reflectors, nearly the same results as an emissive system can be obtained by use of the three colors cyan, yellow, and magenta as the primary colors, from which all other colors, including black but not white, can be derived. To obtain white from such a display, one must further introduce a third state per sub-pixel, namely white.

One means of generating color in a microencapsulated display medium is the use of color filters in conjunction with a contrast-generating optical element. One manifestation of this technique is to use a pixel element which switches between white and black. This, in conjunction with the color filter, allows for switching between a light and dark colored state to occur. However, it is known to those skilled in the art that different numbers of color filters (ranging from one to three) can be used in a sub-pixel, depending on how many colors are desired. Also, the microencapsulated particle display can switch between colors other than white and black. In this case, it is advantageous to use a color filter which is opposed (in a color sense) to the color of the pixel. For example, a yellow color filter used with a blue or white electrophoretic display would result in a green or yellow color to that element.

Additionally, there is an electrophoretic device known as a "shutter mode" display, in which particles are switched electrically between a widely-dispersed state on one electrode and a narrow band on the other electrode. Such a device can act as a transmissive light valve or reflective display. Color filters can be used with such a device.

Referring now to FIGS. 1A and 1B, an addressing scheme for controlling particle-based displays is shown in which electrodes are disposed on only one side of a display, allowing the display to be rear-addressed. Utilizing only one side of the display for electrodes simplifies fabrication of displays. For example, if the electrodes are disposed on only the rear side of a display, both of the electrodes can be fabricated using opaque materials, which may be colored, because the electrodes do not need to be transparent.

FIG. 1A depicts a single capsule 20 of an encapsulated display media. In brief overview, the embodiment depicted in FIG. 1A includes a capsule 20 containing at least one particle 50 dispersed in a suspending fluid 25. The capsule 20 is addressed by a first electrode 30 and a second electrode 40. The first electrode 30 is smaller than the second electrode 40. The first electrode 30 and the second electrode 40 may be set to voltage potentials which affect the position of the particles 50 in the capsule 20.

The particles 50 represent 0.1 % to 20% of the volume enclosed by the capsule 20. In some embodiments the particles 50 represent 2.5% to 17.5% of the volume enclosed by capsule 20. In preferred embodiments, the particles 50 represent 5% to 15% of the volume enclosed by the capsule 20. In more preferred embodiments the particles 50 represent 9% to 11% of the volume defined. by the capsule 20. In general, the volume percentage of the capsule 20 that the particles 50 represent should be selected so that the particles 50 expose most of the second, larger electrode 40 when positioned over the first, smaller electrode 30. As described in detail below, the particles 50 may be colored any one of a number of colors. The particles 50 may be either positively charged or negatively charged.

The particles 50 are dispersed in a dispersing fluid 25. The dispersing fluid 25 should have a low dielectric constant. The fluid 25 may be clear, or substantially clear, so that the fluid 25 does not inhibit viewing the particles 50 and the electrodes 30, 40 from position 10. In other embodiments, the fluid 25 is dyed. In some embodiments the dispersing fluid 25 has a specific gravity matched to the density of the particles 50. These embodiments can provide a bistable display media, because the particles 50 do not tend to move in certain compositions absent an electric field applied via the electrodes 30, 40.

The electrodes 30, 40 should be sized and positioned appropriately so that together they address the entire capsule 20. There may be exactly one pair of electrodes 30, 40 per capsule 20, multiple pairs of electrodes 30, 40 per capsule 20, or a single pair of electrodes 30, 40 may span multiple capsules 20. In the embodiment shown in FIGs. 1A and 1B, the capsule 20 has a flattened, rectangular shape. In these embodiments, the electrodes 30, 40 should address most, or all, of the flattened surface area adjacent the electrodes 30, 40. The smaller electrode 30 is at most one-half the size of the larger electrode 40. In preferred embodiments the smaller electrode is one-quarter the size of the larger electrode 40; in more preferred embodiments the smaller electrode 30 is one-eighth the size of the larger electrode 40. In even more preferred embodiments, the smaller electrode 30 is one-sixteenth the size of the larger electrode 40. It should be noted that reference to "smaller" in connection with the electrode 30 means that the electrode 30 addresses a smaller amount of the surface area of the capsule 20, not necessarily that the electrode 30 is physically smaller than the larger electrode 40. For example, multiple capsules 20 may be positioned such that less of each capsule 20 is addressed by the "smaller" electrode 30, even though both electrodes 30, 40 are equal in size. It should also be noted that electrode 30 may address only a small comer of a rectangular capsule 20 requiring the larger electrode 40 to surround the smaller electrode 30 on two sides in order to properly address the capsule 20. Selection of the percentage volume of the particles 50 and the electrodes 30, 40 in this manner allow the encapsulated display media to be addressed as described below.

Electrodes 30, 40 may be fabricated using transparent materials such as indium tin oxide and conductive polymers such as polyaniline or polythiopenes.

As already mentioned, in the display element of FIG. 1A, the capsule 20 contains at least one dark or black particle 50 dispersed in the substantially clear dispersing fluid 25. The smaller, opaque electrode 30 and the larger, transparent electrode 40 apply both direct-current (DC) electric fields and alternating-current (AC) fields to the capsule 20. A DC field can be applied to the capsule 20 to cause the particles 50 to migrate towards the smaller electrode 30. For example, if the particles 50 are positively charged, the smaller electrode is placed a voltage that is more negative than the larger electrode 40. Although FIGS. 1A-1D depict only one capsule per electrode pair, multiple capsules may be addressed using the same electrode pair.

Causing the particles 50 to migrate to the smaller electrode 30, as depicted in FIG. 1A, allows incident light to pass through the larger, transparent electrode 40 and be reflected by a reflecting surface 60. In shutter mode, the reflecting surface 60 is replaced by a translucent layer or a transparent layer, and incident light is allowed to pass through the capsule 20, i.e. the capsule 20 is transmissive. If the translucent layer or the transparent layer comprises a color, such as a color filter, the light which is transmitted will be those wavelengths that the filter passes, and the reflected light will consist of those wavelengths that the filter reflects, while the wavelengths that the filter absorbs will be lost. The visual appearance of a shutter mode display may thus depend on whether the display is in a transmissive or reflective condition, on the characteristics of the filter, and on the position of the viewer.

Referring now to FIG. 1B, the particles 50 are dispersed into the capsule 20 by applying an AC field to the capsule 20 via the electrodes 30, 40. The particles 50, dispersed into the capsule 20 by the AC field, block incident light from passing through the capsule 20, causing it to appear dark at the viewpoint 10. The embodiment depicted in FIGs. 1A-1B may be used in shutter mode by not providing the reflecting surface 60 and instead providing a translucent layer, a transparent layer, or a color filter layer. In shutter mode, application of an AC electric field causes the capsule 20 to appear opaque.. The transparency of a shutter mode display formed by the apparatus depicted in FIGs. 1A-1B may be controlled by the number of capsules addressed using DC fields and AC fields. For example, a display in which every other capsule 20 is addressed using an AC field would appear fifty percent transmissive.

FIGs. 1C and 1D depict an embodiment of the invention in which electrodes 30, 40 are on "top" of the capsule 20, that is, the electrodes 30, 40 are between the viewpoint 10 and the capsule 20. In this embodiment, both electrodes 30, 40 should be transparent. Transparent polymers can be fabricated using conductive polymers, such as polyaniline, polythiophenes, or indium tin oxide. These materials may be made soluble so that electrodes can be fabricated using coating techniques such as spin coating, spray coating, meniscus coating, printing techniques, forward and reverse roll coating and the like. Light passes through the electrodes 30, 40 and is either absorbed by the particles 50, or partially transmitted and/or reflected if a color filter is present as layer 60.

Referring to FIG. 1E, three sub-pixel capsules 22, 22' and 22" each contain at least one white particle 50 dispersed in a substantially clear dispersing fluid 25. Each sub-pixel capsule 22, 22' and 22" has a transparent electrode 42, 42', and 42" disposed above it and a colored filter 60, 60' and 60" disposed below it. A common reflective surface 70 may be shared behind the color filter layer. In an alternative embodiment, the display includes an emissive light source 70.

Smaller, opaque electrodes 30, 30' and 30" and larger, transparent electrodes 40, 40' and 40" may apply direct-current (DC) electric fields and alternating-current (AC) fields to the capsules 20, 20' and 20". A DC field can be applied to the capsules 20, 20' and 20" to cause the particles 50, 50' 50" to migrate towards the smaller electrodes 30, 30' and 30". For example, if the particles 50, 50' and 50" are positively charged, the smaller electrodes 30, 30' and 30" are placed a voltage that is more negative than the larger electrodes 40, 40' and 40".

The smaller electrode 30 is at most one-half the size of the larger electrode 40. In preferred embodiments the smaller electrode 30 is one-quarter the size of the larger electrode 40; in more preferred embodiments the smaller electrode 30 is one-eighth the size of the larger electrode 40. In even more preferred embodiments, the smaller electrode 30 is one-sixteenth the size of the larger electrode 40.

Causing the particles 50 to migrate to the smaller electrode 30, as depicted in the first two capsules of FIG. 1E, allows incident light to pass through the larger, transparent electrode 40 filter 60 and reflect off substrate 70. If the first, second and third filters 60, 60' and 60" are colored cyan, magenta, and yellow respectively, and the particles 50 are white, this system can display full color in a standard two-color fashion.

The filter layer 60 may be a translucent layer, a transparent layer, or a color filter layer, and further substrate 70 may be reflective, emissive, translucent or not provided at all. If the layer 60 comprises a color, such as a color filter, the light which is transmitted will be those wavelengths that the filter passes, and the reflected light will consist of those wavelengths that the filter reflects, while the wavelengths that the filter absorbs will be lost. The visual appearance of a the display element in FIG. 1E may thus depend on whether the display is in a transmissive or reflective condition, on the characteristics of the filter, and on the position of the viewer. In an alternative embodiment layer 60 may be provided on top of the capsule adjacent to electrode 42.

In FIGS. 1F-1K, one embodiment of a tri-color pixel is illustrated. Clear electrode 42 allows light to pass into capsule 22 and to strike either white particles W, red particles R, or a colored substrate 60. The substrate 60 can be a combination of color filter and non-colored substrate. Capsule 22 also includes a suspending fluid that can be dye-colored or substantially clear. Electrodes 45 and 35 are transparent and may be equally sized or sized in any suitable manner taking into account the relative particles sizes and mobilities of particles W and R. A gap exists between 45 and 35. Assume that particles W are negatively charged and particles R are positively charged. In FIG. 1F, top electrode 42 is set at a positive voltage potential relative to bottom electrodes 35 and 45, moving particles W to the top and particles R to the bottom and thus white is displayed. In FIG. I G by reversing the polarity of the electrodes, red is displayed. In both FIGS. 1 F and 1 G the particles obscure substrate 60. In FIG. 1H electrode 45 is at a negative voltage potential relative to electrode 35, while electrode 42 is at a voltage potential between the potentials of 45 and 35, such as zero. Alternatively, electrode 42 switches between the potentials of 45 and 35 so that over time the effective voltage of 42 is again between the potentials of 45 and 35. In this state, the particles R move toward electrode 45 and the particles W move toward electrode 35 and both particles R and W move away from the gap in the center of the capsule 22. This reveals substrate 60, permitting a third color such as cyan to be imaged. In alternate embodiments the color combinations can differ. The specific colors of the filters and particles need not differ. This system, called "dual particle curtain mode," can image three arbitrary colors. In a preferred embodiment the colors are as described wherein one color is white and the other two colors are complements. In this manner, referring again. to FIG. 1H, if a small portion of red is visible it absorbs part of the light reflected from the cyan substrate and the net result is black, which may be offset by a small portion of visible white. Thus, the pixel in FIG. 1H may appear to be cyan even if some red and white is visible. As mentioned above, the edges of the pixel may be masked to hide particles R and W when in the mode shown in FIG. 1H.

Referring now to FIG. 11, a full-color pixel is shown comprising three sub-pixels, each operating in the manner taught by FIGS. 1F-1H wherein the colored particles are positively charged, and the white particles are negatively charged. The system may still function with top electrode 42 extended as a common top electrode as shown in FIG. 1I. For example, to achieve the state shown, electrodes 42, 45, 35, 45', 35', 45", 35" may be set to voltage potentials - 30V, 60V, 60V, -60V, +60V, -60V, +60V respectively.

Referring now to FIGS. 1J-1K, an electrode scheme is shown whereby a cluster of microcapsules may be addressed for an entire sub-pixel in a manner similar to those described above. Clear electrode 42 allows light to pass into microcapsules 27 and to strike either white particles W, red particles R, or colored substrate 60. As above, colored substrate 60 may be a combination of color filter and non-colored substrate. Capsules 27 include a suspending fluid that may be dye-colored or substantially clear. Electrodes 45 and 35 are transparent and may be equally sized or sized in any suitable manner taking into account the relative particle sizes and mobilities of particles W and R. A gap exists between 45 and 35. Assume that particles W are negatively charged and particles R are positively charged. The system operates in the manner described in FIGS. 1F-1K, although for any given microcapsule 27 there may be multiple gaps. FIG. 1 K illustrates an embodiment of a suitable electrode pattern in which 45 and 35 are interdigitated.

The addressing structure depicted in FIGS. 1A-1K may be used with electrophoretic display media and encapsulated electrophoretic display media. FIGS. 1A-1K depict embodiments in which electrode 30, 40 are statically attached to the display media. In certain embodiments, the particles 50 exhibit bistability, that is, they are substantially, motionless in the absence of a electric field.

While various of the substrates described above are reflective, an analogous technique may be employed wherein the substrates emit light, with the particles again acting in a "shutter mode" to reveal or obscure light. A preferred substrate for this use is an electroluminiscent (EL) backlight. Such a backlight can be reflective when inactive, often with a whitish-green color, yet emit lights in various wavelengths when active. By using whitish EL substrates in place of static white reflective substrates, it is possible to construct a full-color reflective display that can also switch its mode of operation to display a range of colors in an emissive state, permitting operation in low ambient light conditions.

The addressing structures shown in the drawings typically comprise a top electrode controlled by display driver circuitry. It may be seen that if the top electrode is absent, the display may be imaged by an externally applied voltage source, such as a passing stylus or electrostatic print head. The means that techniques applied above to generate a full-color electrophoretic display could also be applied for a full-color electrophoretic media.

In an encapsulated electrophoretic image display, an electrophoretic suspension, such as the ones described previously, is placed inside discrete compartments that are dispersed in a polymer matrix. This resulting material is highly susceptible to an electric field across the thickness of the film. Such a field is normally applied using electrodes attached to either side of the material. However, as described above in connection with FIGs. IA- 1F, some display media may be addressed by writing electrostatic charge onto one side of the display material. The other side normally has a clear or opaque electrode. For example, a sheet of encapsulated electrophoretic display media can be addressed with a head providing DC voltages.

In another embodiment, the encapsulated electrophoretic suspension can be printed onto an area of a conductive material such as a printed silver or graphite ink, aluminized mylar, or any other conductive surface. This surface which constitutes one electrode of the display can be set at ground or high voltage. An electrostatic head consisting of many electrodes can be passed over the capsules to addressing them. Alternatively, a stylus can be used to address the encapsulated electrophoretic suspension.

In another embodiment, an electrostatic write head is passed over the surface of the material. This allows very high resolution addressing. Since encapsulated electrophoretic material can be placed on plastic, it is flexible. This allows the material to be passed through normal paper handling equipment. Such a system works much like a photocopier, but with no consumables. The sheet of display material passes through the machine and an electrostatic or electrophotographic head addresses the sheet of material.

In another embodiment, electrical charge is built up on the surface of the encapsulated display material or on a dielectric sheet through frictional or triboelectric charging. The charge can built up using an electrode that is later removed. In another embodiment, charge is built up on the surface of the encapsulated display by using a sheet of piezoelectric material.

Microencapsulated displays offer a useful means of creating electronic displays, many of which can be coated or printed. There are many versions of microencapsulated displays, including microencapsulated electrophoretic displays. These displays can be made to be highly reflective, bistable, and low power.

To obtain high resolution displays, it is useful to use some external addressing means with the microencapsulated material. This invention describes useful combinations of addressing means with microencapsulated electrophoretic materials in order to obtain high resolution displays.

One method of addressing liquid crystal displays is the use of silicon-based thin film transistors to form an addressing backplane for the liquid crystal. For liquid crystal displays, these thin film transistors are typically deposited on glass, and are typically made from amorphous silicon or polysilicon. Other electronic circuits (such as drive electronics or logic) are sometimes integrated into the periphery of the display. An emerging field is the deposition of amorphous or polysilicon devices onto flexible substrates such as metal foils or plastic films.

The addressing electronic backplane could incorporate diodes as the nonlinear element, rather than transistors. Diode-based active matrix arrays have been demonstrated as being compatible with liquid crystal displays to form high resolution devices.

There are also examples of crystalline silicon transistors being used on glass substrates. Crystalline silicon possesses very high mobilities, and thus can be used to make high performance devices. Presently, the most straightforward way of constructing crystalline silicon devices is on a silicon wafer. For use in many types of liquid crystal displays, the crystalline silicon circuit is constructed on a silicon wafer, and then transferred to a glass substrate by a "liftoff" process. Alternatively, the silicon transistors can be formed on a silicon wafer, removed via a liftoff process, and then deposited on a flexible substrate such as plastic, metal foil, or paper. As another embodiment, the silicon could be formed on a different substrate that is able to tolerate high temperatures (such as glass or metal foils), lifted off, and transferred to a flexible substrate. As yet another embodiment, the silicon transistors are formed on a silicon wafer, which is then used in whole or in part as one of the substrates for the display.

The use of silicon-based circuits with liquid crystals is the basis of a large industry. Nevertheless, these display possess serious drawbacks. Liquid crystal displays are inefficient with light, so that most liquid crystal displays require some sort of backlighting. Reflective liquid crystal displays can be constructed, but are typically very dim, due to the presence of polarizers. Most liquid crystal devices require precise spacing of the cell gap, so that they are not very compatible with flexible substrates. Most liquid crystal displays require a "rubbing" process to align the liquid crystals, which is both difficult to control and has the potential for damaging the TFT array.

The combination of these thin film transistors with microencapsulated electrophoretic displays should be even more advantageous than with liquid crystal displays. Thin film transistor arrays similar to those used with liquid crystals could also be used with the microencapsulated display medium. As noted above, liquid crystal arrays typically requires a "rubbing" process to align the liquid crystals, which can cause either mechanical or static electrical damage to the transistor array. No such rubbing is needed for microencapsulated displays, improving yields and simplifying the construction process.

Microencapsulated electrophoretic displays can be highly reflective. This provides an advantage in high-resolution displays, as a backlight is not required for good visibility. Also, a high-resolution display can be built on opaque substrates, which opens up a range of new materials for the deposition of thin film transistor arrays.

Moreover, the encapsulated electrophoretic display is highly compatible with flexible substrates. This enables high-resolution TFT displays in which the transistors are deposited on flexible substrates like flexible glass, plastics, or metal foils. The flexible substrate used with any type of thin film transistor or other nonlinear element need not be a single sheet of glass, plastic, metal foil, though. Instead, it could be constructed of paper. Alternatively, it could be constructed of a woven material. Alternatively, it could be a composite or layered . combination of these materials.

As in liquid crystal displays, external logic or drive circuitry can be built on the same substrate as the thin film transistor switches.

In another embodiment, the addressing electronic backplane could incorporate diodes as the nonlinear element, rather than transistors.

In another embodiment, it is possible to form transistors on a silicon wafer, dice the transistors, and place them in a large area array to form a large, TFT-addressed display medium. One example of this concept is to form mechanical impressions in the receiving substrate, and then cover the substrate with a slurry or other form of the transistors. With agitation, the transistors will fall into the impressions, where they can be bonded and incorporated into the device circuitry. The receiving substrate could be glass, plastic, or other nonconductive material. In this way, the economy of creating transistors using standard processing methods can be used to create large-area displays without the need for large area silicon processing equipment.

## Claims

1. An electrophoretic display element comprising a capsule (20; 22, 22', 22") including at least one species of particles (5.0, 50', 50"; W, R, G, B) with a color, the element presenting a visual display in response to the application of an electrical signal to the capsule,
the element being **characterized by** a filter (60, 60', 60") having a color visually different from that of the species of particles (50, 50', 50"; W, R, G, B), the filter (60, 60', 60") being disposed adjacent the capsule (20; 22, 22', 22") such that, in at least one optical state of the element, light incident on the capsule (20; 22, 22', 22") will pass through the filter (60, 60', 60") so that the visual appearance of the capsule (20; 22, 22', 22") is modified by the presence of the filter (60, 60', 60").

2. An electrophoretic display element according to claim 1 wherein the filter (60, 60', 60") is printed.

3. An electrophoretic display element according to claim 1 comprising a first capsule (22) including a first species of particles (W) having a first color and a second species of particles (R) having a second color visually different from the first color, and a second capsule (22') including a third species of particles (W) having a third color and a fourth species of particles (G) having a fourth color visually different from the first, second and third colors, wherein the first capsule (22) has adjacent thereto a first filter (60) having a fifth color visually different from those of the first (W) and second (R) species of particles, and the second capsule (22') has adjacent thereto a second filter (60') having a sixth color visually different from those of the third (W) and fourth (G) species of particles.

4. An electrophoretic display element according to any one of the preceding claims wherein the capsule, or at least one of the capsules (20; 22, 22', 22"), comprises a suspending fluid (25)

5. An electrophoretic display element according to claim 4 wherein the suspending fluid (25) is substantially clear.

6. An electrophoretic display element according to claim 4 wherein the suspending fluid (25) is dyed.

7. An electrophoretic display element according to any one of the preceding claims wherein the capsule (20; 22, 22', 22") has a first optical state in which the particles (50, 50', 50"; W, R, G, B) are distributed throughout the capsule (20; 22, 22', 22"), and a second optical state in which the particles (50, 50', 50"; W, R, G, B) are held adjacent an electrode (30, 30', 30"; 35, 35', 35", 45, 45', 45") which occupies only a minor portion of the capsule (20; 22, 22', 22").

8. An electrophoretic display element according to any one of the preceding claims wherein the capsule (20; 22, 22', 22") has, on one side thereof, a pair of electrodes (30, 40, 30', 40', 30", 40") of differing sizes.

9. An electrophoretic display element according to claim 8 wherein the filter (60, 60', 60") is disposed on the same side of the capsule (20; 22, 22', 22") as the pair of electrodes (30, 40, 30', 40', 30", 40").

10. An electrophoretic display element according to claim 8 wherein the filter is disposed on the opposed side of the capsule from the pair of electrodes.

11. An electrophoretic display element according to claim 1 wherein the capsule (22, 22', 22") including a first species of particles (W) having a first color and a second species of particles (R, G, B) having a second color visually different from the first color, the display element having a first electrode (42) on one side thereof and spaced second (35, 35'. 35") and third (45, 45', 45") electrodes on the opposed side thereof, the display element having a first optical state in which the first species (W) of particles lie adjacent the first electrode (42) and the second species of particles (R, G, B) lie adjacent the second (35, 35'. 35") and third (45, 45', 45") electrodes, a second optical state in which the second species of particles (R, G, B) lie adjacent the first electrode (42) and the first species (W) of particles lie adjacent the second (35, 35'. 35") and third (45, 45', 45") electrodes, and a third optical state in which the first species (W) of particles lie adjacent the second electrode (35, 35'. 35") and the second species of particles (R, G, B) lie adjacent the third electrode (45, 45', 45").

12. A display apparatus comprising a display element and at least one electrode (30, 30', 30", 40, 40', 40"; 35, 35', 35", 45, 45', 45") adjacent the display element, the apparatus presenting a visual display in response to the application of an electrical signal via the electrode to the display element (30, 30', 30", 40, 40', 40"; 35, 35', 35", 45, 45', 45") , wherein the display element is a display element according to any one of the preceding claims.

13. A display apparatus according to claim 12 having a plurality of electrodes (30, 30', 30", 40, 40', 40") wherein at least one of the electrodes (30, 30', 30", 40, 40', 40") differs in size or color from at least one of the other electrodes (30, 30', 30", 40, 40', 40").

## Patentansprüche

1. Elektrophoretisches Anzeigeelement mit einer Kapsel (20; 22, 22', 22"), die wenigstens eine Art von Partikeln (50, 50', 50"; W, R, G, B) mit einer Farbe enthält, wobei das Element eine visuelle Anzeige beim Anlegen eines elektrischen Signals an die Kapsel liefert,
wobei das Element **gekennzeichnet ist durch** ein Filter (60, 60', 60"), das eine Farbe aufweist, die visuell von jener der Art der Partikel (50, 50', 50"; W, R, G, B) unterschieden ist und wobei das Filter (60, 60', 60") benachbart zur Kapsel (20; 22, 22', 22") derart angeordnet ist, dass bei wenigstens einem optischen Zustand des Elementes das auf die Kapsel (20; 22, 22', 22") einfallende Licht **durch** das Filter (60, 60', 60") derart hindurchtritt, dass das visuelle Erscheinungsbild der Kapsel (20; 22, 22', 22") **durch** das Vorhandensein des Filters (60, 60', 60") modifiziert wird.

2. Elektrophoretisches Anzeigeelement nach Anspruch 1, bei welchem das Filter (60, 60', 60") aufgedruckt ist.

3. Elektrophoretisches Anzeigeelement nach Anspruch 1, bei welchem eine erste Kapsel (22) eine erste Art von Partikeln (W) mit einer ersten Farbe und eine zweite Art von Partikeln (R) mit einer zweiten Farbe aufweist, die visuell von der ersten Farbe unterschieden ist und eine zweite Kapsel (22') eine dritte Art von Partikeln (W) aufweist, die eine dritte Farbe haben und eine vierte Art von Partikeln (G) vorgesehen ist, die eine vierte Farbe besitzt, die visuell von der ersten, zweiten und dritten Farbe unterschieden ist, wobei die erste Kapsel (22) benachbart hierzu ein erstes Filter (60) aufweist, das eine fünfte Farbe besitzt, die visuell von jenen Farben der ersten (W) und zweiten (R) Art von Partikeln unterschieden ist und die zweite Kapsel (22') benachbart hierzu ein zweites Filter (60') aufweist, das eine sechste Farbe besitzt, die visuell von der Farbe der dritten (W) und vierten (G) Art von Partikeln unterschieden ist.

4. Elektrophoretisches Anzeigeelement nach einem der vorhergehenden Ansprüche, bei welchem die Kapsel oder wenigstens eine der Kapseln (20; 22, 22', 22") ein Suspendierungsfluid (25) aufweist.

5. Elektrophoretisches Anzeigeelement nach Anspruch 4, bei welchem das Suspendierungsfluid (25) im Wesentlichen klar ist.

6. Elektrophoretisches Anzeigeelement nach Anspruch 4, bei welchem das Suspendierungsfluid (25) gefärbt ist.

7. Elektrophoretisches Anzeigeelement nach einem der vorhergehenden Ansprüche, bei welchem die Kapsel (20; 22, 22', 22") einen ersten optischen Zustand aufweist, in dem die Partikel (50, 50', 50"; W, R, G, B) über die Kapsel (20; 22, 22', 22") verteilt sind und ein zweiter optischer Zustand vorgesehen ist, in dem die Partikel (50, 50', 50"; W, R, G, B) benachbart zu einer Elektrode (30, 30', 30"; 35, 35', 35", 45, 45', 45") gehalten werden und in diesem Zustand nur einen kleineren Abschnitt der Kapsel (20; 22, 22', 22") einnehmen.

8. Elektrophoretisches Anzeigeelement nach einem der vorhergehenden Ansprüche, bei welchem die Kapsel (20; 22, 22', 22") an einer Seite hiervon ein Paar von Elektroden (30, 40, 30', 40', 30", 40") unterschiedlicher Abmessungen aufweist.

9. Elektrophoretisches Anzeigeelement nach Anspruch 8, bei welchem das Filter (60, 60', 60") auf der gleichen Seite der Kapsel (20; 22, 22', 22") wie das Paar von Elektroden (30, 40, 30', 40', 30", 40") angeordnet ist.

10. Elektrophoretisches Anzeigeelement nach Anspruch 8, bei welchem das Filter auf der dem Paar von Elektroden gegenüberliegenden Seite angeordnet ist.

11. Elektrophoretisches Anzeigeelement nach Anspruch 1, bei welchem die Kapsel (22, 22', 22") eine erste Art von Partikeln (W) aufweist, die eine erste Farbe besitzt und eine zweite Art von Partikeln (R, G, B) vorgesehen ist, die eine zweite Farbe besitzt, die visuell unterschiedlich von der ersten Farbe ist, wobei das Anzeigeelement eine erste Elektrode (42) auf einer Seite hiervon aufweist und im Abstand angeordnete zweite (35, 35', 35") und dritte (45, 45', 45") Elektroden auf der gegenüberliegenden Seite vorgesehen sind und das Anzeigeelement einen ersten optischen Zustand besitzt, in dem die erste Art (W) von Partikeln benachbart zur ersten Elektrode (42) liegt und die zweite Art von Partikeln (R, G, B) benachbart zur zweiten (35, 35', 35") und dritten (45, 45', 45" Elektrode befindlich ist und wobei ein zweiter optischer Zustand vorhanden ist, in dem die zweite Art von Partikeln (R, G, B) benachbart zur ersten Elektrode (42) liegt und die erste Art (W) von Partikeln benachbart zur zweiten (35, 35', 35") und dritten (45, 45', 45") Elektrode befindlich ist, während bei einem dritten optischen Zustand die erste Art (W) von Partikeln benachbart zur zweiten Elektrode (35, 35', 35") und die zweite Art von Partikeln (R, G, B) benachbart zur dritten Elektrode (45, 45', 45") liegt.

12. Anzeigevorrichtung mit einem Anzeigeelement und wenigstens einer Elektrode (30, 30', 30", 40, 40', 40"; 35, 35', 35", 45, 45', 45") benachbart zum Anzeigeelement, wobei die Vorrichtung eine visuelle Anzeige präsentiert, wenn ein elektrisches Signal über die Elektrode an das Anzeigeelement (30, 30', 30", 40, 40', 40"; 35, 35', 35", 45, 45', 45") angelegt wird, wobei das Anzeigeelement ein Anzeigeelement gemäß einem der vorhergehenden Ansprüche ist.

13. Anzeigevorrichtung nach Anspruch 12 mit mehreren Elektroden (30, 30', 30", 40, 40', 40"), bei welcher wenigstens eine der Elektroden (30, 30', 30", 40, 40', 40") sich in Größe oder Farbe von wenigstens einer der anderen Elektroden (30, 30', 30", 40, 40', 40") unterscheidet.

## Revendications

1. Elément d'affichage électrophorétique comprenant une capsule (20 ; 22, 22', 22") comportant au moins une espèce de particules (50, 50', 50" ; W, R, G, B) ayant une couleur, l'élément présentant un affichage visuel en réponse à l'application d'un signal électrique à la capsule,
l'élément étant **caractérisé par** un filtre (60, 60', 60") ayant une couleur visuellement différente de celle de l'espèce des particules (50, 50', 50" ; W, R, G, B), le filtre (60, 60', 60") étant placé au voisinage de la capsule (20 ; 22, 22', 22") de manière telle que, dans au moins un état optique de l'élément, la lumière arrivant sur la capsule (20 ; 22, 22', 22") passe par le filtre (60, 60', 60"), de sorte que l'apparence visuelle de la capsule (20 ; 22, 22', 22") est modifiée par la présence du filtre (60, 60', 60").

2. Elément d'affichage électrophorétique selon la revendication 1, dans lequel le filtre (60, 60', 60") est imprimé.

3. Elément d'affichage électrophorétique selon la revendication 1, comprenant une première capsule (22) comportant une première espèce de particules (W) ayant une première couleur et une deuxième espèce de particules (R) ayant une deuxième couleur visuellement différente de la première couleur, et une deuxième capsule (22') comportant une troisième espèce de particules (W) ayant une troisième couleur et une quatrième espèce de particules (G) ayant une quatrième couleur visuellement différente des première, deuxième et troisième couleurs, dans lequel la première capsule (22) a dans son voisinage un premier filtre (60) ayant une cinquième couleur visuellement différente de celles des première (W) et deuxième (R) espèces de particules, et la deuxième capsule (22') a dans son voisinage un deuxième filtre (60') ayant une sixième couleur visuellement différente de celles des troisième (W) et quatrième (G) espèces de particules.

4. Elément d'affichage électrophorétique selon l'une quelconque des revendications précédentes, dans lequel la capsule, ou au moins l'une des capsules (20 ; 22, 22', 22"), comprend un fluide de suspension (25).

5. Elément d'affichage électrophorétique selon la revendication 4, dans lequel le fluide de suspension (25) est substantiellement transparent.

6. Elément d'affichage électrophorétique selon la revendication 4, dans lequel le fluide de suspension (25) est teinté.

7. Elément d'affichage électrophorétique selon l'une quelconque des revendications précédentes, dans lequel la capsule (20 ; 22, 22', 22") a un premier état optique dans lequel les particules (50, 50', 50" ; W, R, G, B) sont réparties dans toute la capsule (20 ; 22, 22', 22"), et un deuxième état optique dans lequel les particules (50, 50', 50" ; W, R, G, B) sont maintenues au voisinage d'une électrode (30, 30', 30" ; 35, 35', 35", 45, 45', 45") qui n'occupe qu'une petite partie de la capsule (20 ; 22, 22', 22").

8. Elément d'affichage électrophorétique selon l'une quelconque des revendications précédentes, dans lequel la capsule (20 ; 22, 22', 22") a, sur un de ses côtés, une paire d'électrodes (30, 40, 30', 40', 30", 40") de tailles différentes.

9. Elément d'affichage électrophorétique selon la revendication 8, dans lequel le filtre (60, 60', 60") est placé du même côté de la capsule (20 ; 22, 22', 22") que la paire d'électrodes (30, 40, 30', 40', 30", 40").

10. Elément d'affichage électrophorétique selon la revendication 8, dans lequel le filtre est placé du côté opposé à la paire d'électrodes par rapport à la capsule.

11. Elément d'affichage électrophorétique selon la revendication 1, dans lequel la capsule (22, 22', 22") comportant une première espèce de particules (W) ayant une première couleur et une deuxième espèce de particules (R, G, B) ayant une deuxième couleur visuellement différente de la première couleur, l'élément d'affichage ayant une première électrode (42) sur un de ses côtés et des deuxième (35, 35', 35") et troisième (45, 45', 45") électrodes espacées sur son côté opposé, l'élément d'affichage ayant un premier état optique dans lequel la première espèce (W) de particules se trouve au voisinage de la première électrode (42) et la deuxième espèce de particules (R, G, B) se trouve au voisinage des deuxième (35, 35', 35") et troisième (45, 45', 45") électrodes, un deuxième état optique dans lequel la deuxième espèce de particules (R, G, B) se trouve au voisinage de la première électrode (42) et la première espèce (W) de particules se trouve au voisinage des deuxième (35, 35', 35") et troisième (45, 45', 45") électrodes, et un troisième état optique dans lequel la première espèce (W) de particules se trouve au voisinage de la deuxième électrode (35, 35', 35") et la deuxième espèce de particules (R, G, B) se trouve au voisinage de la troisième électrode (45, 45', 45").

12. Dispositif d'affichage comprenant un élément d'affichage et au moins une électrode (30, 30', 30", 40, 40', 40" ; 35, 35', 35", 45, 45', 45") voisine de l'élément d'affichage, le dispositif présentant un affichage visuel en réponse à l'application d'un signal électrique via l'électrode à l'élément d'affichage (30, 30', 30", 40, 40', 40" ; 35, 35', 35", 45, 45', 45"), où l'élément d'affichage est un élément d'affichage conforme à l'une quelconque des revendications précédentes.

13. Dispositif d'affichage selon la revendication 12 comportant une pluralité d'électrodes (30, 30', 30", 40, 40', 40"), au moins l'une des électrodes (30, 30', 30", 40, 40', 40") étant différente, en taille ou en couleur, d'au moins l'une des autres électrodes (30, 30', 30", 40, 40', 40").
